# EUROPEAN PATENT APPLICATION

(11) **EP 2 587 909 A1**
(43) Date of publication of application: **01.05.2013**
(21) Application number: 11800849.9
(22) Date of filing: 28.06.2011
(51) Int. Cl.: H05K 9/00, G02B 6/42

(54) **ELECTRONIC COMPONENT**

(30) Priority: 28.06.2010 JP 2010146290
(71) Applicant: Yazaki Corporation, Minato-ku Tokyo 108-8333 (JP)
(72) Inventor: MIYAKAWA, Daisuke, Shizuoka 410-1107 (JP)
(74) Representative: Grünecker, Kinkeldey, Stockmair & Schwanhäusser
(86) International application number: PCT/JP2011/064804
(87) International publication number: WO 2012/002385

(57) **Abstract**

To provide an electronic component capable of obtaining a high electromagnetic noise removing performance.

There are provided an electronic component body 2 having an optical transceiver 5, a shield case 20 disposed on an upper surface, both of side surfaces and a rear surface of the electronic component body 2, and an option pin 7 disposed at a front of the optical transceiver 5 and conducted to the shield case 20.

## Description

### <TECHNICAL FIELD>

The present invention relates to an electronic component having a shield case.

### <BACKGROUND ART>

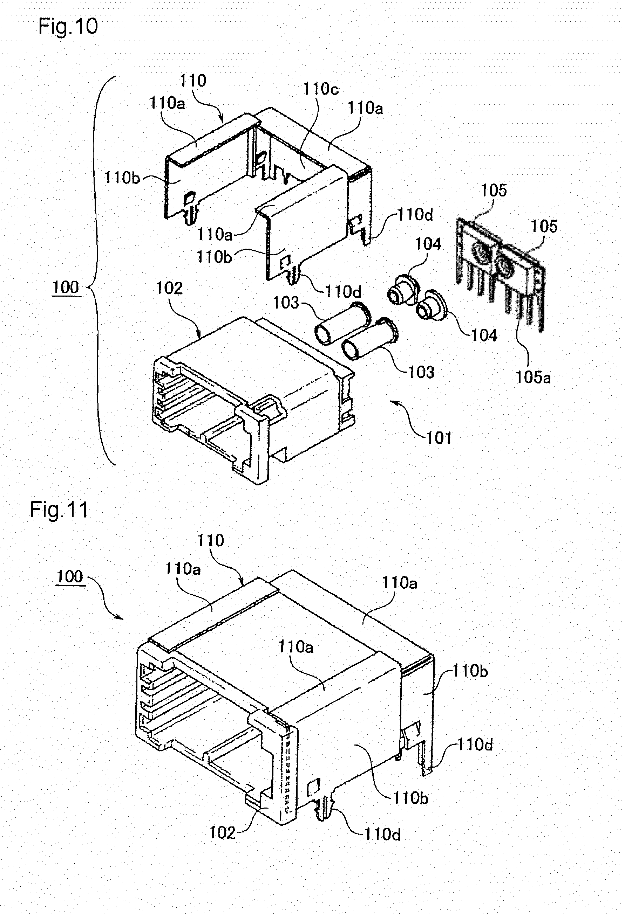

An electronic component of this type according to the conventional example is disclosed in Patent Document 1. An optical connector 100 to be the electronic component includes an electronic component body 101 and a shield case 110 for covering an outer periphery of the electronic component body 101 as shown in Figs. 10 and 11. The electronic component body 101 includes a housing 102, a pair of sleeves 103 inserted in a pair of holes provided on a partition wall (not shown) of the housing 102, a pair of optical guiding members 104 inserted in the pair of sleeves 103 from behind, and an optical transceiver (FOT : Fiber Optical Transceiver) 105 disposed on a rear surface side of the pair of optical guiding members 104.

The shield case 110 includes three upper surface piece portions 110a, a pair of side surface portions 110b and a rear surface portion 110c. A plurality of ground pins 110d is protruded downward from lower end surfaces of the pair of side surface portions 110b and the rear surface portion 110c.

The shield case 110 is put on the outer periphery of the electronic component body 101 through a case opening at a lower surface side and is thus attached to the electronic component body 101.

Each of the ground pins 110d is connected to a predetermined conductor portion (not shown) of a substrate for mounting (not shown) together with a lead portion 105a of the optical transceiver 105 by soldering or the like.

In the conventional example, an electromagnetic wave emitted from each optical transceiver 105 to an outside and an electromagnetic wave incident on the optical transceiver 105 from the outside are shielded by the shield case 110. Therefore, it is possible to prevent a bad influence from being caused by the electromagnetic wave as greatly as possible.

### <PRIOR ART DOCUMENT>

### <PATENT DOCUMENT>

Patent Document 1 : JP-A-2009-111114 Publication

### <SUMMARY OF THE INVENTION>

### <PROBLEMS TO BE SOLVED BY THE INVENTION>

In the optical connector 100 according to the conventional example, however, the shield case 110 simply covers a partial upper surface together with whole regions of the both side surfaces and the rear surface of the electronic component body 101. For this reason, there is a problem in that a high electromagnetic noise removing performance cannot be obtained. When a communication speed is increased, particularly, there is a possibility that the conventional shield case 110 cannot effectively remove an electromagnetic noise.

Therefore, the invention has been made to solve the problem and has an object to provide an electronic component capable of obtaining a high electromagnetic noise removing performance.

### <MEANS FOR SOLVING THE PROBLEMS>

The object of the invention can be achieved by the following structures.
(1) An electronic component including an electronic component body having an electronic element, a shield case disposed on an upper surface, both of side surfaces and a rear surface of the electronic component body, and an auxiliary shield member disposed at a front of the electronic element and conducted to the shield case.

(2) The electronic component having the structure of (1), wherein the auxiliary shield member is removably provided in the electronic component body.

(3) The electronic component having the structure of (1) or (2), wherein the auxiliary shield member has a grounding connection portion.

### <BRIEF DESCRIPTION OF THE DRAWINGS>

Fig. 1 is a perspective view showing an embodiment according to the invention as seen from a front side of an optical connector,
Fig. 2 is a perspective view showing the embodiment according to the invention as seen from a rear surface side of the optical connector,
Fig. 3 is an exploded perspective view showing the embodiment according to the invention as seen from the front side of the optical connector,
Fig. 4 is an A - A line sectional view of Fig. 2 according to the embodiment of the invention,
Fig. 5 is a front view showing an option pin according to the embodiment of the invention,
Fig. 6 is a perspective view showing the embodiment according to the invention as seen from a bottom surface side of the optical connector,
Fig. 7 is a perspective view showing a shield case and the option pin according to the embodiment of the invention, a part of which is taken away,
Fig. 8 is a perspective view showing a process for attaching the shield case from above an electronic component body according to the embodiment of the invention,
Fig. 9 is a perspective view showing a process for attaching the option pin from a lower surface of the electronic component body according to the embodiment of the invention,
Fig. 10 is an exploded perspective view showing an optical connector according to the conventional example, and
Fig. 11 is a perspective view showing the optical connector according to the conventional example.

### <MODE FOR CARRYING OUT THE INVENTION>

An embodiment according to the invention will be described below with reference to the drawings.

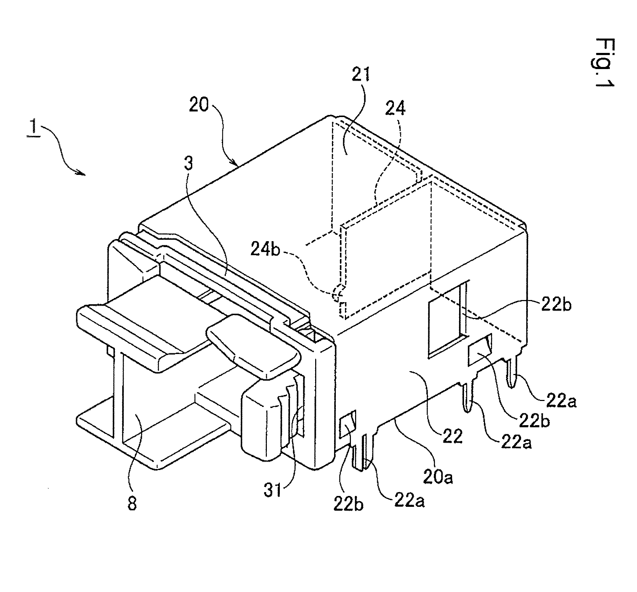

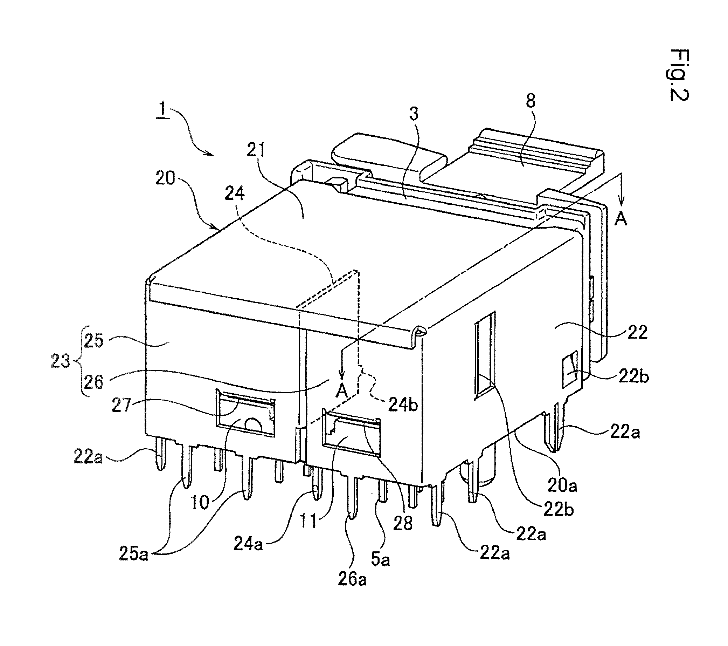

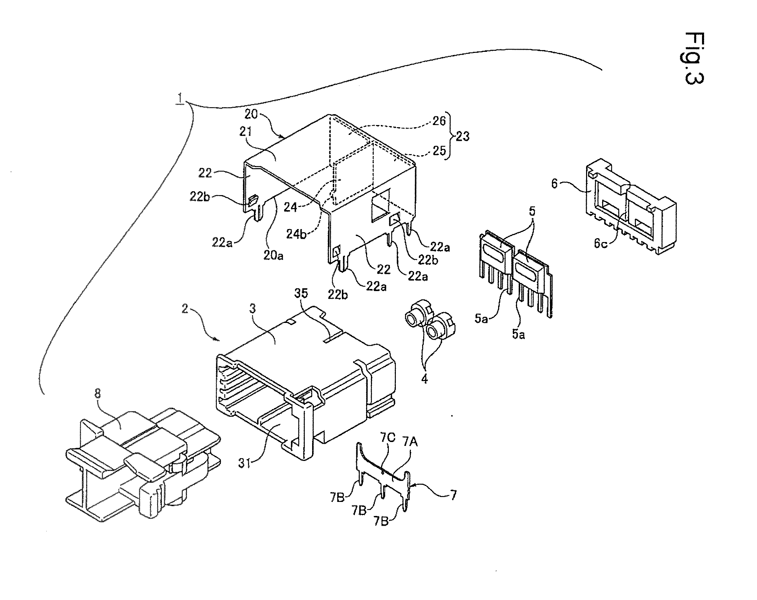

In Figs. 1 to 3, an optical connector 1 to be an electronic component includes an electronic component body 2 and a shield case 20 for covering an outer periphery of the electronic component body 2.

The electronic component body 2 includes a housing 3, a pair of lenses 4, an optical transceiver (FOT : Fiber Optical transceiver) 5 to be a pair of electronic elements, an electronic element cover 6, and an option pin 7 to be an auxiliary shield member.

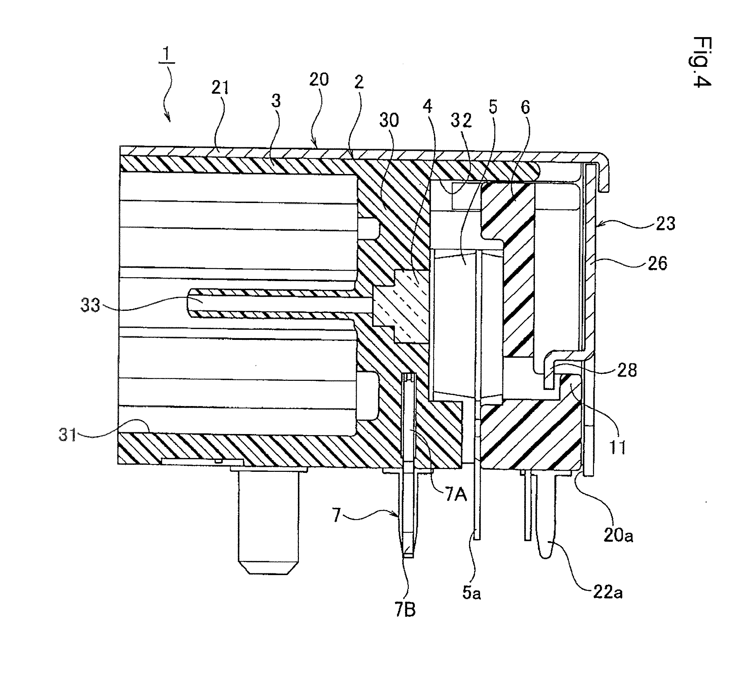

As shown in Fig. 4, the housing 3 has a partition wall 30 therein. A connector fitting chamber 31 and a component housing chamber 32 are provided in the housing 3 with the partition wall 30 set to be a boundary. A partner side connector (not shown) is fitted in the connector fitting chamber 31. Figs. 1 to 3 show a state in which a dust cap 8 is attached to the connector fitting chamber 31. The dust cap 8 is used for preventing dust or the like from entering the connector fitting chamber 31 in non-attachment of the partner connector (not shown).

A pair of cylindrical optical fiber positioning portions 33 is protruded from the partition wall 30 toward the connector fitting chamber 31. When the partner side connector (not shown) is fitted, tip parts of a pair of optical fibers (not shown) in the partner side connector (not shown) are positioned by the respective optical fiber positioning portions 33. The component housing chamber 32 is caused to penetrate through an inner part of each of the optical fiber positioning portions 33.

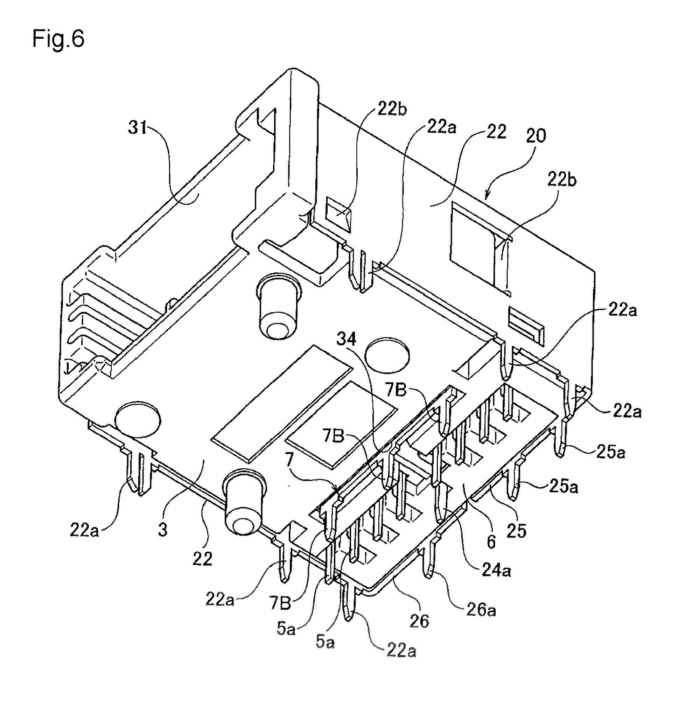

A pin push-in slit 34 is provided on a bottom part at the component housing chamber 32 side from the partition wall 30 of the housing 3 (see Fig. 6). The pin push-in slit 34 is formed on a bottom surface of the component housing chamber 32. A center slit 35 is provided on an upper wall portion at the component housing chamber 32 side from the partition wall 30 of the housing 3. The center slit 35 is formed on an upper surface of the component housing chamber 32.

In Figs. 1 to 4, the pair of lenses 4 is disposed on the component housing chamber 32 to face openings of the respective optical fiber positioning portions 33. The pair of lenses 4 is disposed in parallel with at least a position on an extended line of the center slit 35 on the housing 3 left.

The pair of optical transceivers 5 is disposed on the component housing chamber 32 in rear end positions of the lenses 4. One of the optical transceivers 5 is a light emitting device and the other is a light receiving device, for example. Each of the optical transceivers 5 has a plurality of lead portions 5a protruded downward. The respective lead portions 5a are connected to corresponding conductor portions of a mounting substrate (not shown) by soldering or the like. The pair of optical transceivers 5 is disposed in parallel with at least the position on the extended line of the center slit 35 in the housing 3 left.

The electronic element cover 6 is disposed on both rear surfaces of the pair of optical transceivers 5. The electronic element cover 6 is fitted in the housing 3. The pair of optical transceivers 5 is fixed to the housing 3 through the electronic element cover 6. A cover side slit 6c is provided in a central position of the electronic element cover 6. Although the cover side slit 6c is opened on an upper end surface of the electronic element cover 6 and is extended vertically in a downward direction, it does not reach a lower end surface. The cover side slit 6c is positioned on the extended line of the center slit 35 in the housing 3. In other words, a partition case portion 24 in the shield case 20 which will be described below is disposed by utilizing the center slit 35 of the housing 3 and a space on the extended line.

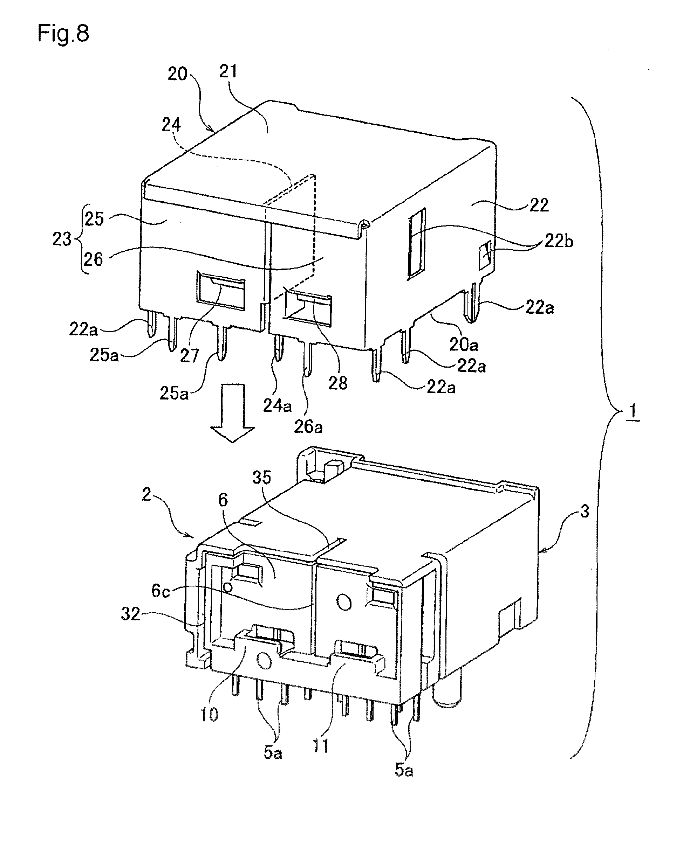

Position controlling portions 10 and 11 are provided on rear surfaces of the electronic element covers 6 respectively (see Fig. 8).

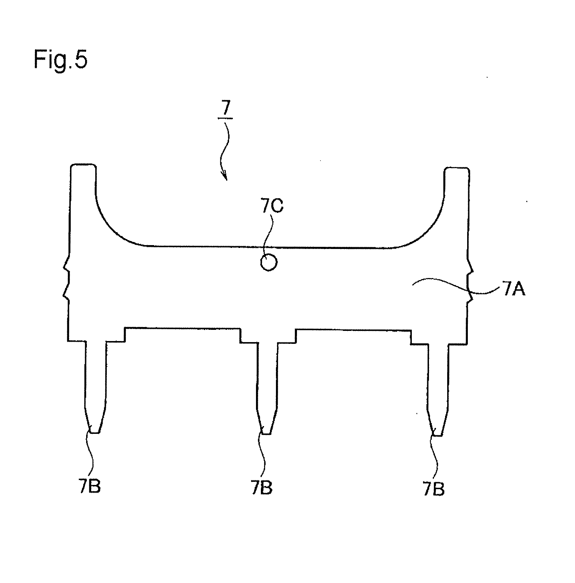

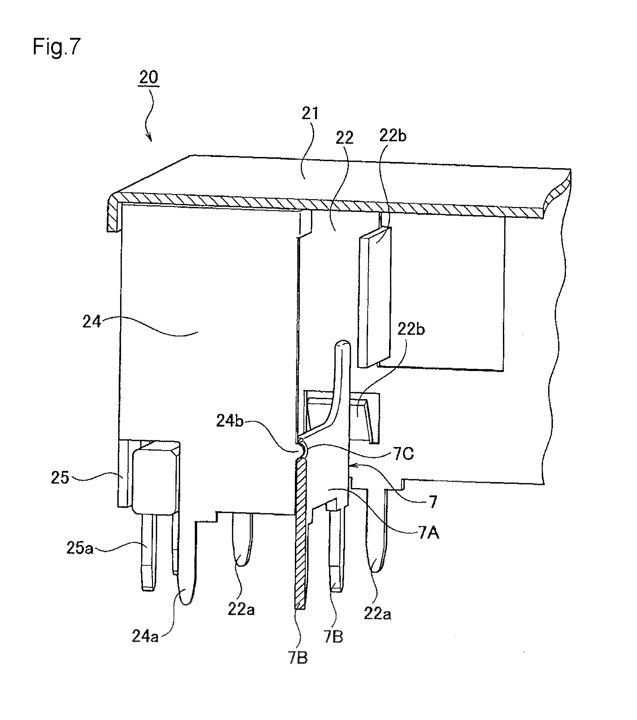

As shown in Figs. 5 to 7 in detail, the option pin 7 is an option member to be assembled if necessary. The option pin 7 is formed by a conductive metal plate. The option pin 7 is constituted by a shield plate portion 7A and a plurality of ground pin portions 7B to be grounding connection portions protruded downward from the shield plate portion 7A. An engaging hole 7C is formed on the shield plate portion 7A. The option pin 7 is pushed into the pin push-in slit 34 of the housing 3. The engaging hole 7C is engaged with an engaging protruded portion 24b of the shield case 20 so that the option pin 7 is conducted to the shield case 20. The shield plate portion 7A of the option pin 7 is disposed at a front of the pair of optical transceivers 5 (see Fig. 4). Each ground pin portion 7B of the option pin 7 is connected to a grounding conductor portion of the mounting substrate (not shown) by soldering or the like. When the option pin 7 is pulled out against an engaging force between the engaging hole 7C and the engaging protruded portion 24b and a push-in force to the housing 3, moreover, it can be removed. In other words, the option pin 7 is removably provided on the electronic component body 2.

The shield case 20 is formed by punching and bending a conductive metal plate. The shield case 20 is almost box-shaped in which a lower surface is set to be a case opening 20a. The shield case 20 has an upper surface case portion 21, left and right side surface case portions 22 and a rear surface case portion 23, and furthermore, includes a partition case portion 24 disposed to divide a rear part of an inner portion through a center. The rear surface case portion 23 is constituted by two divided case piece portions 25 and 26. The partition case portion 24 is formed by bending from an end surface at a central side of at least one of the two divided case piece portions 25 and 26. A tip surface of the partition case portion 24 is provided with the engaging protruded portion 24b.

Ground pins 22a, 24a, 25a and 26a to be grounding connection portions are protruded downward at lower ends of the respective side surface case portions 22, the partition case portion 24, and the respective divided case piece portions 25 and 26. The respective ground pins 22a, 24a, 25a and 26a are connected to the grounding conductor portion of the mounting substrate (not shown) by soldering or the like.

An engaging click 22b is provided on the left and right side surface case portions 22 by inward bending, respectively. Each engaging click 22b is engaged with the housing 3. Consequently, the shield case 20 is not removed from the electronic component body 2.
Position controlled portions 27 and 28 are provided on the divided case piece portions 25 and 26 by the inward bending, respectively. As shown in Fig. 4, the left and right position controlled portions 27 and 28 are engaged with the left and right position controlling portions 10 and 11 of the electronic cover 6, respectively.

Next, description will be given to a work for attaching the shield case 20. As shown in Fig. 8, the shield case 20 is put on the electronic component body 2 from the case opening 20a side. Consequently, both of the side surface case portions 22 and the rear surface case portion 23 of the shield case 20 gradually cover the outer periphery of the electronic component body 2, and furthermore, the partition case portion 24 enters the component housing chamber 32 through the center slit 35 of the housing 3. When the covering is performed to reach a position in which the upper surface case portion 21 of the shield case 20 abuts on the upper surface of the electronic component body 2, each engaging click 22b is engaged with the housing 3. Moreover, a lower end surface of the partition case portion 24 enters a close part to a lower end of the cover side slit 6c of the electronic element cover 6 so that the partition case portion 24 partitions the pair of optical transceivers 5.

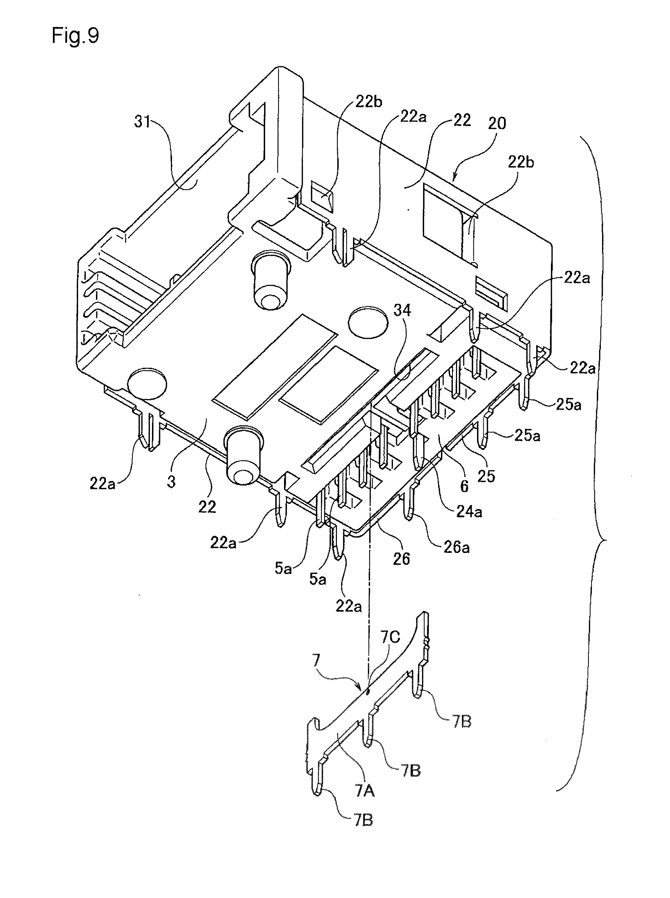

In the case in which the option pin 7 is attached, the option pin 7 is pushed in through the pin push-in slit 34 of the housing 3 as shown in Fig. 9. When the option pin 7 is pushed into a push-in completing position, the engaging protruded portion 24b of the partition case portion 24 is engaged with the engaging hole 7C of the option pin 7. The shield plate portion 7A of the option pin 7 is disposed at the front of the respective optical transceivers 5 (see Fig. 4).

In the substrate mounting of the optical connector 1, the lead portion 5a of each optical transceiver 5, the ground pins 22a, 24a, 25a and 26a of the shield case 20 and the ground pin portion 7B of the option pin 7 are connected to a corresponding conductor portion of the substrate (not shown) by soldering or the like.

With the structure, each optical transceiver 5 has the shield case 20 disposed on the upper surface side, both of the side surface sides and the rear surface side thereof, and furthermore, has the shield plate portion 7A of the option pin 7 disposed on the front side thereof. In addition, the option pin 7 is conducted to the shield case 20 so that a noise can be removed by the whole shield case 20 and option pin 7. Thus, it is possible to obtain a high electromagnetic noise removing performance.

The pair of optical transceivers 5 is divided by the partition case portion 24. Therefore, it is also possible to prevent a bad influence from being caused by mutual electromagnetic noises between the pair of optical transceivers.

The option pin 7 is removably provided on the electronic component body 2. Accordingly, the option pin 7 does not need to be attached to the electronic component body 2 if not necessary. Moreover, the option pin 7 attached to the electronic component body 2 can easily be removed in a disassembly. Therefore, an environment supposing an easy disassembling property is greatly taken into consideration.

The option pin 7 has the ground pin portion 7B. Therefore, the noise removing performance can be enhanced.

Although the electronic component is the optical connector 1 in the embodiment, it is a matter of course that the invention can also be applied to an electronic component other than the optical connector 1.
Although the electronic component according to the invention has been described above in detail with reference to the specific embodiment, the embodiment is only illustrative for the typical mode of the invention and the invention is not restricted to the embodiment. In other words, various changes can be made for enforcement without departing from the gist of the invention.
The application is based on Japanese Patent Application No. 2010-146290) filed on June 28, 2010 and the content is incorporated herein by reference.

### <INDUSTRIAL APPLICABILITY>

According to an electronic component of the invention, a shield case is disposed on an upper surface side, both of side surface sides and a rear surface side of an electronic element, and furthermore, an auxiliary shield member is disposed at a front side of the electronic element. In addition, the auxiliary shield member is conducted to the shield case, and a noise can be removed by the whole shield case and auxiliary shield member. Thus, it is possible to obtain a high electromagnetic noise removing performance.

### <EXPLANATION OF DESIGNATION>

| | |
|---|---|
| 1 | optical connector (electronic component) |
| 2 | electronic component body |
| 5 | optical transceiver (electronic element) |
| 7 | option pin (auxiliary shield member) |
| 7B | ground pin portion (grounding connection portion) |
| 20 | shield case |

## Claims

1. An electronic component comprising:
an electronic component body having an electronic element;
a shield case disposed on an upper surface, both of side surfaces and a rear surface of the electronic component body; and
an auxiliary shield member disposed at a front of the electronic element and conducted to the shield case.

2. The electronic component according to claim 1, wherein the auxiliary shield member is removably provided in the electronic component body.

3. The electronic component according to claim 1 or 2, wherein the auxiliary shield member has a grounding connection portion.
